# EUROPEAN PATENT APPLICATION

(11) **EP 4 621 844 A1**
(43) Date of publication of application: **24.09.2025**
(21) Application number: 25159436.2
(22) Date of filing: 21.02.2025
(51) Int. Cl.: H01L 23/38, H01L 25/065, H01L 23/538, H01L 23/15, H01L 25/16, H01L 25/18

(54) **INTERPOSER FOR THERMALLY ENGINEERED ELECTRO-OPTICAL MULTICHIP MODULES**

(30) Priority: 22.02.2024 US 202463556589 P; 17.02.2025 US 202519055118
(71) Applicant: II-VI Delaware, Inc., Wilmington, DE 19890 (US)
(72) Inventor: Clarici, Georg, Wilmington, DE (US); Lange, Enrico, Wilmington, DE (US); Varon, Andres, Wilmington, DE (US); Domburg, Patrick, Wilmington, DE (US)
(74) Representative: Forresters IP LLP

(57) **Abstract**

A multi-chip-module includes, from a bottom to a top thereof, a substrate and an interposer disposed on the substrate. The interposer is electrically non-conductive and has a thermal conductivity (k) of k < 20 W/(mK). A set of integrated circuit components or chips is disposed on the interposer. Each of a first subset of the set of the components or chips includes a passive heat spreader disposed on the chip. At least one chip of a second subset of the components or chips includes an active heat spreader disposed on the chip. The first and second sets of the components or chips have no components or chips in common. A common thermal interface is disposed on each passive heat spreader and each active heat spreader.

## Description

### CROSS-REFERENCE TO RELATED APPLICATION

This application claims priority to U.S. Provisional Patent Application No. 63/556,589, filed February 22, 2024, the disclosure of which is hereby incorporated by reference in its entirety.

### BACKGROUND

### Field

The present disclosure relates to multi-chip-modules (MCMs) and, more particularly, to thermal management of the integrated circuit (IC) chips and/or components of said MCMs.

### Description of Related Art

Next generation optical interfaces for coherent optical signal transmission require denser packaging than before. New generation MCMs may include, among other things, one or more IC chips as well as one or more Electro-Optical (EO) components and/or chips on a common substrate. This is, in part, driven by the need to have short high-speed/high-frequency electrical connections between the IC chip(s) and the EO component(s) and/or chip(s).

In new generation MCMs, connections from the IC chip(s) and the EO component(s) and/or chip(s) to one or more peripherial devices are routed through the substrate to its bottom side which offers a suitable electrical interface to a host printed circuit board (PCB) which may support or provide connection to the one or more peripherial input/output (I/O) devices.

A unique requirement of some EO component(s) and/or chip(s) is that they require a specific operating temperature. This unique requirement is not present in IC chip(s).

To efficiently achieve a specific operating temperature, the EO component(s) and/or chip(s) need to be thermally insulated from the (often high-power dissipation) IC chip(s). Since heat flows upwardly in the IC chip(s) and the EO component(s) and/or chip(s) of MCMs, a common heat spreader may be disposed on the topsides of the IC chip(s) and the EO component(s) and/or chip(s) with the substrate disposed below the electronic and EO chips. This substrate, however, may cause unwanted thermal crosstalk.

### SUMMARY

Disclosed herein is the use of an electrically non-conductive interposer with low thermal conductivity disposed between chips on the interposer and a substrate. This interposer will also comprise electrical conductors for carrying signals (e.g., high-speed signals) between the chips. The interposer may be made of any suitable and/or desirable low thermal conductivity material, e.g., without limitation, glass or fused silica, which combines low thermal conductivity and good RF properties. Herein, good RF properties of the interposer may include the interposer being formed of a material that allows the formation of RF waveguides/lines on or in the interposer with a bandwidth ≥ 70GHz.

Also disclosed herein is a multi-chip-module comprising from a bottom to a top thereof: a substrate; an interposer disposed on the substrate, wherein the interposer is electrically non-conductive and has a thermal conductivity (k) of k < 20 W/(mK), wherein: W = watts, m=meter, and K= kelvin; a set of integrated circuit components or chips disposed on the interposer, wherein: each of a first subset of the set of the components or chips includes a passive heat spreader disposed on the chip; and at least one chip of a second subset of the components or chips includes an active heat spreader disposed on the chip, wherein the first and second sets of the components or chips have no components or chips in common; and a common thermal interface disposed on each passive heat spreader and each active heat spreader.

### BRIEF DESCRIPTION OF THE DRAWINGS

Fig. 1 is a side schematic view of a multi-chip-module in accordance with the principles of the present disclosure;
Fig. 2 is a schematic section of the multi-chip-module of Fig. 1 taken along lines II-II in Fig. 1; and
Fig. 3 is a side schematic view of another multi-chip-module in accordance with the principles of the present disclosure.

### DETAILED DESCRIPTION

Various non-limiting embodiments will now be described with reference to the accompanying figures where like reference numbers correspond to like or functionally equivalent elements or features.

As used herein, spatial, or directional terms, such as "left", "right", "inner", "outer", "above", "below", "top side", "bottom side", and the like, relate to the disclosure as it is shown in the drawing figures. However, it is to be understood that the disclosure can assume various alternative orientations and, accordingly, such terms are not to be considered as limiting. Further, as used herein, all numbers expressing dimensions, physical characteristics, processing parameters, quantities of ingredients, reaction conditions, and the like, used in the specification and claims are to be understood as being modified in all instances by the term "approximately" or "about". Accordingly, unless indicated to the contrary, the numerical values set forth in the following specification and claims may vary depending upon the desired properties sought to be obtained by the present disclosure.

At the very least, and not as an attempt to limit the application of the doctrine of equivalents to the scope of the claims, each numerical value should at least be construed in light of the number of reported significant digits and by applying ordinary rounding techniques. Moreover, all ranges disclosed herein are to be understood to encompass the beginning and ending range values and any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 1 to 3.3, 4.7 to 7.5, 5.5 to 10, and the like. "A" or "an" refers to one or more.

As used herein, "coupled", "coupling", "disposed", "mounted" and similar terms refer to two or more elements that are joined, linked, fastened, connected, put in communication, or otherwise associated (e.g., mechanically, electromagnetically, fluidly, optically) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the phrase "at least one of", when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of" may be, for example, without limitation, two of item A, one of item B, and ten of item C; four of item B and seven of item C; and other suitable combinations.

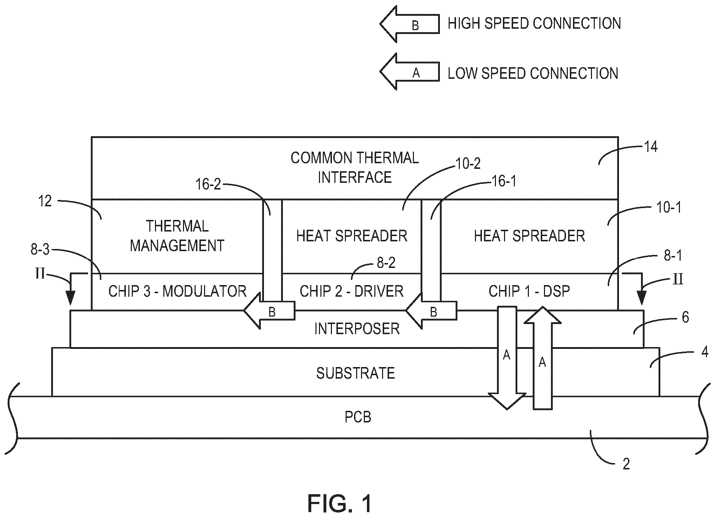

With reference to Fig. 1, an example multi-chip-module in accordance with the principles of the present disclosure may comprise from a bottom to a top thereof a substrate 4 mounted on a host printed circuit board (PCB) 2. An interposer 6 may be disposed on the substrate 4. In an example, the interposer 6 may be electrically non-conductive and may have a thermal conductivity (k) of k < 20 W/(mK), wherein: W = watts, m=meter, and K=kelvin. However, other values of k are envisioned. In an example, the interposer 6 having a resistance of ≥ 1E10 ohmmeter may be considered electrically non-conductive.

A set of integrated circuit (IC) components or chips may be disposed on the interposer 6. In an example, the set of IC components or chips may include chips 1-3. In a non-limiting example, chip 1 8-1 may be a digital signal processor (DSP) chip, chip 2 8-2 may be a driver chip, and chip 3 8-3 may be a modulator component or chip. However, this is not to be construed in a limiting sense since it is envisioned that each chip 1-3 may be any suitable and/or desirable chip for a particular application. Herein, when referring to chip 3, the terms "chip" and "component" may be used interchangeably.

In an example, chip 1 8-1 and chip 2 8-2 may comprise integrated circuit chips, such as CMOS-chips, GaAs chips, SiGe chips, InP chips, or some combination thereof. In an example, chip 2 8-2 may be an analog mixed signal chip such as an RF chip. In an example, chip 3 8-3 may comprise an EO component or chip comprising, for example, without limitation, one or more of the following: a laser, a waveguide, a modulator, a light amplifier, and/or one or more photodiodes that may require a specific operating temperature or max operating temperature not present in the electronic chips.

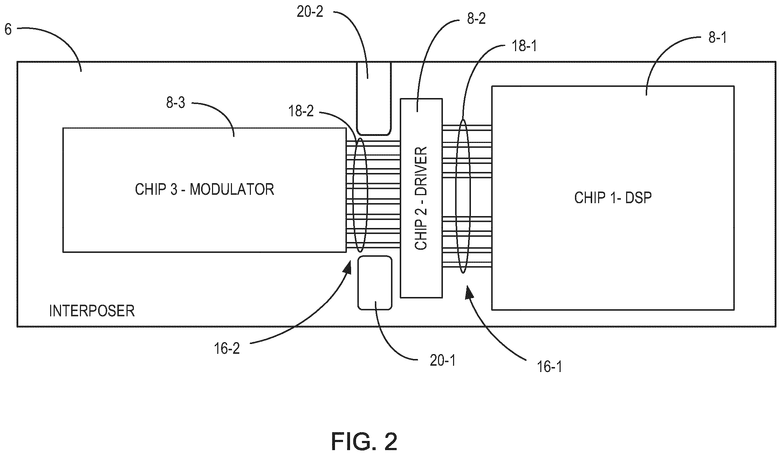

With reference to Fig. 2 and with continuing reference to Fig. 1, in an example, chip 1 and chip 2 may be spaced from each other by a space 16-1 on the interposer 6 which may include, on or adjacent the top surface thereof, conductive traces 18-1 configured to communicatively connect chip 1 and chip 2 in a manner known in the art. In an example, chip 2 and chip 3 may be spaced from each other by a space 16-2 on the interposer 6 which may include, on or adjacent the top surface thereof, conductive traces 18-2 configured to communicatively connect chip 2 and chip 3 in a manner known in the art. In an example, conductive traces 18-1 and 18-2 may be disposed on the top surface of the interposer 6 and/or in one or more so-called redistribution layers below the top surface of the interposer 6.

The interposer 6 may be made of any suitable and/or desirable low thermal conductivity material, e.g., without limitation, glass or fused silica, which combines low thermal conductivity and good RF properties. Herein, good RF properties of the interposer 6 may include the interposer 6 being formed of a material that allows the formation of one or more of the conductive traces 18-1 and/or 18-2 in the nature of RF waveguides/lines on or in the interposer 6 with a bandwidth ≥ 70GHz.

The interposer 6 and the substrate 4 may include vertically conductive vias and, optionally, horizontally conductive traces (other than conductive traces 18-1 and 18-2) configured to electrically connect conductors including the conductive traces 18-1 and 18-2 of the interposer 6 to conductors including conductive traces of the PCB 2, e.g., on the top surface and/or in one or more redistribution layers of the PCB 2 below the top surface of the PCB 2. In an example, the vertically conductive vias and, optionally, horizontally conductive traces may be configured to communicatively connect at least chip 1 8-1, for example, to external components and/or chips (not shown) via the PCB 2. In an example, the conductive vias and, the optional conductive traces of the interposer 6 and the substrate 4 may be used for bidirectional communication between the external components and/or chips and at least chip 1 8-1.

In an example, the conductive vias and optional conductive traces of the interposer 6 and the substrate 4 may provide low speed communication connections (shown by arrows A in Fig. 1), e.g., DC to 100 Mbps between the PCB 2 and at least chip 1 8-1. In another example, the conductive traces 18 that run at least along the top surface of the interposer 6 and may provide high speed communication connections (shown by arrows B in Fig. 1), e.g., > 10 Gbps and, preferably > 100 Gbps, horizontally between chips 1-3 and, in a specific example, between chip 1 8-1 and chip 2 8-2, and between chip 2 8-2 and chip 3 8-3. However, this is not to be construed in a limiting sense.

In an example, the conductive vias and, optionally, the conductive traces of the interposer 6 and the substrate 4 may also provide electrical pathways for providing electrical biases to chips 1-3 and a thermal management 12 (discussed in greater detail hereinafter) from one or more external power supplies (not shown) via the PCB 2.

In an example, chip 1 8-1 through chip 3 8-3 may be coupled, mechanically and electrically, to interposer 6, which in-turn may be coupled, mechanically and electrically, to substrate 4, which in-turn may be coupled, mechanically and electrically, to PCB 2 using any suitable and/or desirable surface mount technology known in the art, e.g., ball-grid array technology.

In an example, at least one, preferably both, of chip 1 8-1 and/or chip 2 8-2 may include a heat spreader 10-1 and/or 10-2 disposed thereon. In an example, each heat spreader 10 may be a passive heat spreader such as, for example, one or more of the following: a metal, e.g., copper or aluminum, plate; a ceramic plate; a layer of compound semiconductor, e.g., SiC; a layer of diamond; a thermal interface tape or paste; a vapor chamber; a graphite or graphene sheet; and/or a heat pipe. In an example, chip 3 8-3 may include a thermal management 12 disposed thereon. In an example, the thermal management 12 may comprise an active component, such as a heater or a thermo-electric cooler, which may be operative and/or configured to maintain chip 3 8-3, during use thereof, at or below a desired operating temperature.

Finally, the multi-chip-module may include a common thermal interface 14 disposed on top of the heat spreader(s) 10-1 and 10-2, the thermal management 12, and over the spaces 16-1 and 16-2 therebetween. In the orientation shown in Fig. 1, the top of the thermal management 12 will be a so-called "hot side" which will be in contact with the portion of the bottom of common thermal interface 14 in alignment with the thermal management 12. In an example, the common thermal interface may be a passive heat spreader such as, for example, one or more of the following: a metal, e.g., copper or aluminum, plate; a ceramic plate; a layer of compound semiconductor, e.g., SiC; a layer of diamond; a thermal interface tape or paste; a vapor chamber; a graphite or graphene sheet; and/or a heat pipe.

With continuing reference to Fig. 2, in an example, the interposer 6 may include one or more cavities 20 to reduce thermal conductivity between chip 3 and chips 1 and/or 2. In an example, the one or more cavities 20 may include cavities 20-1 and 20-2 disposed between conductors 18-2 and the bottom and top edges (in the orientation shown Fig. 2) of the interposer 6. In the example shown in Fig. 2, cavity 20-1 may not extend to (is spaced from) the bottom edge (in the orientation shown Fig. 2) of the interposer 6 while the cavity 20-2 may extend to the top edge (in the orientation shown Fig. 2) of the interposer 6. However, this is not to be construed in a limiting sense since it is envisioned that each cavity 20 may be spaced from or extend to a corresponding edge of the interposer 6 as may be deemed suitable and/or desirable for a particular application. Moreover, each cavity 20 may extend partially or completely through the thickness of the interposer 6 as may be deemed suitable and/or desirable for a particular application.

With continuing reference to Fig. 1, in an example, it is envisioned that the functions of chip 1 8-1 and chip 2 8-2, for example, may be combined, e.g., into a single chip 8, whereupon, in Fig. 1, the chip combined into the single chip 8 and its heat spreader 10may be omitted; the common thermal interface 14 may be sized to be in contact with the tops of the remaining heat spreader 10 and the thermal management 12 (perhaps with some overhang of the common thermal interface 14 beyond the top(s) of the remaining heat spreader 10 and/or the thermal management 12); and, as needed, the low speed communication connections (shown by arrows A in Fig. 1) may be relocated to run between the single chip 2 8 and the PCB 2.

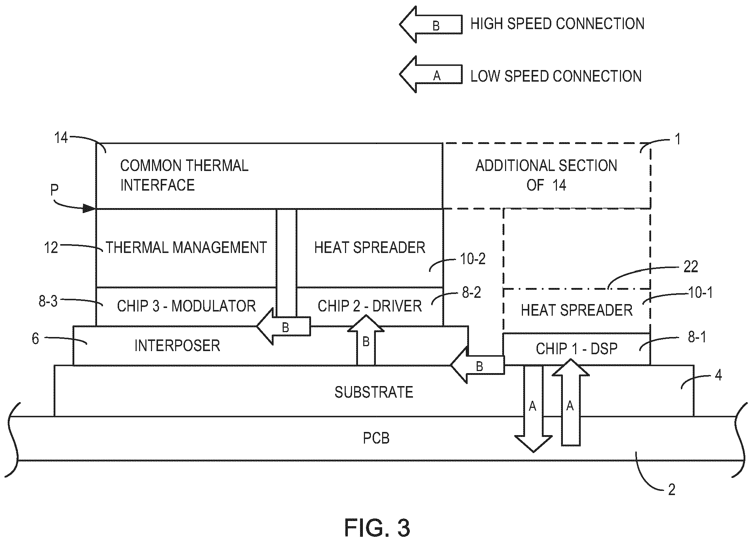

With reference to Fig. 3, another example of a multi-chip-module in accordance with the principles of the present disclosure may be similar to the example multi-chip-module shown in Fig. 1 with at least the following exceptions: chip 1 8-1 may be mounted directly on the substrate 4; chip 2 8-2 and chip 3 8-3 may be mounted on the interposer 6 with the heat spreader 10-2 and the thermal management 12 disposed between chip 2 8-2 and chip 3 8-3 and the common thermal interface 14; the low speed communication connections (shown by arrows A in Fig. 3) may run through the substrate 4 between chip 1 8-1 and the PCB 2; the high speed communication connections or conductive traces (shown by arrows B in Fig. 3) may run laterally on the top of substrate 4 or within redistribution layers adjacent the top of substrate 4 between chip 1 8-1 and the bottom of the interposer 6 below chip 2 8-2, vertically through the interposer 6 between the substrate 4 and chip 2 8-2, and laterally between chip 2 8-2 and chip 3 8-3.

In an example, heat spreader 10-1 (shown in phantom) may or may not be disposed on top of chip 1 8-1. In the case where heat spreader 10-1 (shown in phantom) is not disposed on top of chip 1 8-1, the common thermal interface 14 may be sized to contact the tops of the heat spreader 10-2 and the thermal management 12 (perhaps with some overhang of the common thermal interface 14 beyond the top(s) of the heat spreader 10-2 and/or the thermal management 12).

In the case where the heat spreader 10-1 (shown in phantom) is indeed disposed on top of chip 1 8-1, in one example, the height of the heat spreader 10-1 may be selected whereupon the tops of the heat spreaders 10-1 and 10-2 and the top of the thermal management 12 may all be at or about the same plane P and the common thermal interface 14 may include an additional section 14 (shown in phantom) in contact with the top of the heat spreader 10-1 (in addition to to the tops of the heat spreader 10-2 and the thermal management 12 in contact with the common thermal interface 14).

In the case where the heat spreader 10-1 (shown in phantom) is disposed on top of chip 1 8-1, but the top of the heat spreader 10-1 (shown by the dash-dot line 22 in Fig. 3) is disposed below the level of the top of the heat spreader 10-2 and the top of the thermal management 12 (i.e., the top of the heat spreader 10-1 is disposed below the level of the plane P), the additional section (shown in phantom) of the common thermal interface 14 may be omitted, whereupon only the tops of the heat spreader 1-2 and the thermal management 12 are in contact with the common thermal interface 14.

Other non-limiting examples or aspects of this disclosure are set forth in the following illustrative and exemplary numbered clauses.

Clause 1: A multi-chip-module comprising from a bottom to a top thereof: a substrate; an interposer disposed on the substrate, wherein the interposer is electrically non-conductive and has a thermal conductivity (k) of k < 20 W/(mK), wherein: W = watts, m=meter, and K= kelvin; a set of integrated circuit components or chips disposed on the interposer, wherein: each of a first subset of the set of the components or chips includes a passive heat spreader disposed on the chip; and each of a second subset of the components or chips includes an active heat spreader disposed on the chip, wherein the first and second sets of the components or chips have no components or chips in common; and a common thermal interface disposed on each passive heat spreader and each active heat spreader.

Clause 2: The multiple integrated circuit chip module of clause 1 may further include a set of conductors electrically connecting the set of chips.

Clause 3: The multiple integrated circuit chip module of clause 1 or 2, wherein the set of conductors may be disposed on the interposer between the interposer and the set of chips.

Clause 4: The multiple integrated circuit chip module of any one of clauses 1-3, wherein the interposer may comprise glass.

Clause 5: The multiple integrated circuit chip module of any one of clauses 1-4, wherein the interposer may comprise fused silica.

Clause 6: The multiple integrated circuit chip module of any one of clauses 1-5, wherein the interposer may include one or more cavities configured to reduce a thermal conductivity of the interposer between at least two of the chips of the set of chips.

Clause 7: The multiple integrated circuit chip module of any one of clauses 1-6 may further include a set of conductors disposed through the interposer electrically connecting the substrate to at least one chip of the set of chips.

Clause 8: The multiple integrated circuit chip module of any one of clauses 1-7, may further include a set of conductors disposed through the substrate and electrically connected to the set of conductors disposed through the interposer.

Clause 9: The multiple integrated circuit chip module of any one of clauses 1-8, wherein the set of conductors may be disposed through the substrate and the set of conductors disposed through the interposer may be configured to route one or more electrical signals conducted to or from the substrate from an external source from or to at least one chip of the set of chips.

Clause 10: The multiple integrated circuit chip module of any one of clauses 1-9, wherein the active heat spreader may comprise a heater or a thermo-electric cooler.

Clause 11: The multiple integrated circuit chip module of any one of clauses 1-10, wherein the common thermal interface may comprise at least one of the following: a metal plate; a ceramic plate; a germanium plate, a layer of compound semiconductor; a layer of diamond; a thermal interface tape or paste; a vapor chamber; a graphite or graphene sheet; and/or a heat pipe.

Clause 12: The multiple integrated circuit chip module of any one of clauses 1-11, wherein each passive heat spreader may comprise at least one of the following: a metal plate; a ceramic plate; a germanium plate, a layer of compound semiconductor; a layer of diamond; a thermal interface tape or paste; a vapor chamber; a graphite or graphene sheet; and/or a heat pipe.

Clause 13: The multiple integrated circuit chip module of any one of clauses 1-12, wherein the first subset of the set of the components or chips may include a single component or chip.

Clause 14: The multiple integrated circuit chip module of any one of clauses 1-13, wherein the second subset of the set of the components or chips may include a single component or chip.

Clause 15: The multiple integrated circuit chip module of any one of clauses 1-14 may further include a component or chip disposed on the substrate.

Clause 16: The multiple integrated circuit chip module of any one of clauses 1-15 may further include a passive heat spreader coupled to the component or chip disposed on the substrate.

Clause 17: The multiple integrated circuit chip module of any one of clauses 1-16, wherein the passive heat spreader coupled to the component or chip disposed on the substrate may be spaced from the common thermal interface.

Clause 18: The multiple integrated circuit chip module of any one of clauses 1-17, wherein the passive heat spreader coupled to the component or chip disposed on the substrate may also be coupled to the common thermal interface.

Although this disclosure has been described in detail for the purpose of illustration based on what is currently considered to be the most practical and preferred embodiments, it is to be understood that such detail is solely for that purpose and that the disclosure is not limited to the disclosed embodiments, but, on the contrary, is intended to cover modifications and equivalent arrangements that are within the spirit and scope of the appended claims. For example, it is to be understood that the present disclosure contemplates that, to the extent possible, one or more features of any embodiment or example can be combined with one or more features of any other embodiment or example.

## Claims

1. A multi-chip-module comprising from a bottom to a top thereof:
a substrate;
an interposer disposed on the substrate, wherein the interposer is electrically non-conductive and has a thermal conductivity (k) of k < 20 W/(mK), wherein: W = watts, m=meter, and K= kelvin;
a set of integrated circuit components or chips disposed on the interposer, wherein:
each of a first subset of the set of the components or chips includes a passive heat spreader disposed on the chip; and
each of a second subset of the components or chips includes an active heat spreader disposed on the chip, wherein the first and second sets of the components or chips have no components or chips in common; and
a common thermal interface disposed on each passive heat spreader and each active heat spreader.

2. The multiple integrated circuit chip module of claim 1, further including a set of conductors electrically connecting the set of chips and optionally wherein the set of conductors is disposed on the interposer between the interposer and the set of chips.

3. The multiple integrated circuit chip module of any preceding claim, wherein the interposer comprises glass.

4. The multiple integrated circuit chip module of any preceding claim, wherein the interposer comprises fused silica.

5. The multiple integrated circuit chip module of any preceding claim, wherein the interposer includes one or more cavities configured to reduce a thermal conductivity of the interposer between at least two of the chips of the set of chips.

6. The multiple integrated circuit chip module of any preceding claim, further including a set of conductors disposed through the interposer electrically connecting the substrate to at least one chip of the set of chips.

7. The multiple integrated circuit chip module of claim 6, further including a set of conductors disposed through the substrate and electrically connected to the set of conductors disposed through the interposer and optionally wherein the set of conductors disposed through the substrate and the set of conductors disposed through the interposer are configured to route one or more electrical signals conducted to or from the substrate from an external source from or to at least one chip of the set of chips.

8. The multiple integrated circuit chip module of any preceding claim, wherein the active heat spreader comprises a heater or a thermo-electric cooler.

9. The multiple integrated circuit chip module of any preceding claim, wherein the common thermal interface comprises at least one of the following: a metal plate; a ceramic plate; a germanium plate, a layer of compound semiconductor; a layer of diamond; a thermal interface tape or paste; a vapor chamber; a graphite or graphene sheet; and/or a heat pipe.

10. The multiple integrated circuit chip module of any preceding claim, wherein each passive heat spreader comprises at least one of the following: a metal plate; a ceramic plate; a germanium plate, a layer of compound semiconductor; a layer of diamond; a thermal interface tape or paste; a vapor chamber; a graphite or graphene sheet; and/or a heat pipe.

11. The multiple integrated circuit chip module of any preceding claim, wherein the first subset of the set of the components or chips includes a single component or chip.

12. The multiple integrated circuit chip module of any preceding claim, wherein the second subset of the set of the components or chips includes a single component or chip.

13. The multiple integrated circuit chip module of any preceding claim, further including a component or chip disposed on the substrate.

14. The multiple integrated circuit chip module of claim 13, further including a passive heat spreader coupled to the component or chip disposed on the substrate.

15. The multiple integrated circuit chip module of claim 14, wherein the passive heat spreader coupled to the component or chip disposed on the substrate is spaced from the common thermal interface or wherein the passive heat spreader coupled to the component or chip disposed on the substrate is also coupled to the common thermal interface.
